# FASCICULE DE BREVET EUROPEEN

(11) **EP 3 722 254 B1**
(45) Date de publication et mention de la délivrance du brevet: **16.10.2024**
(21) Numéro de dépôt: 20168372.9
(22) Date de dépôt: 07.04.2020
(51) Int. Cl.: B81B 3/00

(54) **CHARNIERE OFFRANT UNE SENSIBILITE AUX CONTRAINTES INTERNES REDUITE**
SCHARNIER, DAS EINE REDUZIERTE EMPFINDLICHKEIT GEGENÜBER INNENSPANNUNGEN BIETET
HINGE PROVIDING REDUCED SENSITIVITY TO INTERNAL CONSTRAINTS

(30) Priorité: 08.04.2019 FR 1903731
(43) Date de publication de la demande: 14.10.2020
(73) Titulaire: Commissariat à l'énergie atomique et aux énergies alternatives, 75015 Paris (FR)
(72) Inventeur: REY, Patrice, 38054 GRENOBLE CEDEX 09 (FR); JOET, Loic, 38054 GRENOBLE CEDEX 09 (FR); VERDOT, Thierry, 38054 GRENOBLE CEDEX 09 (FR)
(74) Mandataire: Brevalex

(56) Documents cités:
- FR-A1- 2 983 844
- US-A- 5 005 413
- US-A1- 2014 338 450

## Description

### DOMAINE TECHNIQUE ET ÉTAT DE LA TECHNIQUE ANTÉRIEURE

La présente invention se rapporte à une charnière hors-plan pour structure micro et/ou nanomécanique, notamment pour système microélectromécanique, offrant une sensibilité aux contraintes internes réduite.

Les systèmes microélectromécaniques ou MEMS (microelectromechanical systems en terminologie anglo-saxonne) et les systèmes micro et nanoélectromécaniques ou systèmes M&NEMS (micro & nanoelectromechanical systems en terminologie anglo-saxonne) sont utilisés pour réaliser des capteurs ou des actionneurs. Ils comportent au moins un élément mobile par rapport à un substrat. Par exemple dans le cas d'un capteur, le déplacement de la partie mobile ou masse est mesurée et peut être traduit en une caractéristique à détecter, par exemple une accélération, et dans le cas d'un actionneur, l'élément mobile est déplacé par exemple au moyen de forces électrostatiques, par exemple pour déplacer un micromiroir.

L'élément mobile est suspendu par rapport au substrat et suivant les applications on peut souhaiter qu'il ait un déplacement dans le plan du système ou un déplacement hors-plan, i.e. orthogonalement au plan du système.

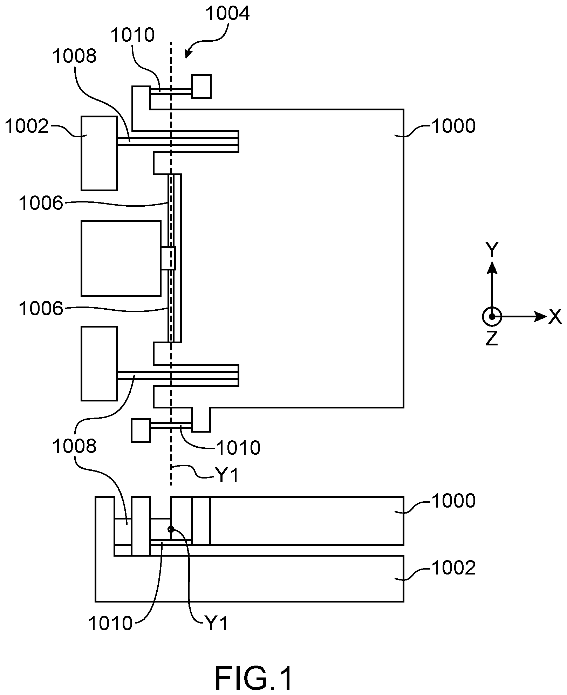

Sur la figure 1, on peut voir un exemple d'une structure microélectromécanique de l'état de la technique.

La structure s'étendant dans le plan XY, comporte une masse 1000 apte à se déplacer dans une direction hors-plan Z par rapport à un support 1002. La structure comporte charnière 1004 entre le support 1002 et la masse 1000 présentant un axe de rotation Y1 dans le plan. La charnière relie un bord de la masse au support. La charnière comporte deux poutres 1006 destinées à être sollicitées en torsion et coaxiales à l'axe de rotation et deux poutres 1008 destinées à être sollicitées en flexion et orthogonales à l'axe de rotation. Les poutres 1006 et 1008 relient la masse au support. Cette structure comporte également deux jauges piézorésistives 1010 permettant de mesurer le déplacement de la masse. Les poutres de flexion 1008 ont pour fonction de rigidifier l'articulation formée par la charnière dans la direction X. Cependant elles provoquent également une rigidification de l'articulation dans la direction hors-plan, ce qui n'est pas souhaitable. Afin de réduire leur effet sur la rigidité dans la direction Z, l'épaisseur des poutres de flexion est réduite.

Une telle structure est réalisée par les procédés de la microélectronique mettant en oeuvre des dépôts, des gravures et une libération de la masse. Par exemple la structure est réalisée par gravure dans une couche formée par épitaxie sur un substrat Silicium sur Isolant ou SOI (Silicon on Insulate) et la masse est libérée en gravant la couche d'oxyde enterrée du substrat SOI.

Lors de la réalisation de la couche par épitaxie, des contraintes sont générées dans la couche. Ces contraintes peuvent notamment être dues au dopage. Par exemple, les atomes de bore sont plus petits que ceux de silicium et induisent une contrainte en compression dans la maille cristalline du silicium. Cette contrainte peut aussi apparaître avant l'épitaxie, lors du dopage de la couche fine du substrat SOI. Lors de la libération de la structure par gravure, ces contraintes dans toutes les couches sont au moins en partie libérées. Or cette libération des contraintes génère un nouvel équilibre des forces et des moments qui peut conduire à une déformation de la structure. Les poutres de flexion sont formées dans la couche épitaxiée. Lors de la libération de la structure, les contraintes dans les poutres se détendent/ se rétractent. Or les jauges, qui sont parallèles aux poutres de flexion, s'opposent à l'expansion/ la rétraction des poutres de flexion. Les poutres de flexion et les jauges étant dans des plans différents, la masse s'incline. Elle n'est alors plus perpendiculaire à l'axe Z. Lorsque les contraintes internes proviennent de la couche fine du substrat SOI, les jauges 1010 n'étant pas alignées, elles vont induire un couple sur la masse et la faire tourner dans le plan. De plus, les contraintes internes de la couche inférieure des poutres de flexion les font fléchir, provoquant une inclinaison de la masse.

Une déformation de la structure peut également survenir lors de la libération de contraintes dans le substrat SOI.

Or cette inclinaison et plus généralement une déformation de la structure ont plusieurs inconvénients. D'une part, elle induit une contrainte dans les jauges, qui peut ne pas être négligeable par rapport à la contrainte à la pleine échelle de mesure, ce qui a pour effet de réduire la plage de variation de la contrainte ou alors peut provoquer un dépassement de la contrainte maximale admissible.

D'autre part, une structure microélectromécanique peut comporter des butées haute et basse pour limiter la course hors-plan de la masse, afin d'éviter le dépassement des contraintes admissibles. Lorsque la masse n'est pas inclinée, elle se trouve au repos à égale distance des butées haute et basse. Or en cas d'inclinaison de la masse, les distances entre la masse et les butées haute et basse sont différentes. Si la masse est inclinée vers le support, la distance entre la masse et la butée basse est inférieure à celle entre la masse et la butée haute. Si l'inclinaison de la masse était connue, les butées pourraient être adaptées pour compenser cette différence de distance, or une telle adaptation complexifie le procédé de réalisation. En outre il est difficile de prévoir l'inclinaison de la masse.

La déformation de la structure peut également survenir en l'absence de jauges de contrainte

De manière générale, il est souhaitable que la structure ne soit pas déformée.

US 2014/338450 et FR 2 983 844 divulguent des charnières pour structure micromécanique et /ou nanomécanique, connues de l'état de la technique.

### EXPOSÉ DE L'INVENTION

Une structure selon l'invention est définie par la revendication 1.

C'est par conséquent un but de la présente invention d'offrir une charnière hors-plan pour structure micro et/ou nanomécanique à sensibilité aux contraintes internes réduite.

Le but énoncé ci-dessus est atteint par une charnière hors-plan pour structure micro et/ou nanomécanique qui comporte un support, au moins une partie mobile dans une direction hors-plan par rapport au support, une charnière destinée à relier la partie mobile au support permettant un déplacement hors-plan de la partie mobile, la charnière comportant au moins un élément destiné à être déformé en torsion et aligné le long de l'axe de rotation de la charnière, et au moins un élément destiné à être déformé en flexion et s'étendant perpendiculairement à l'axe de rotation de la charnière. L'élément de flexion comporte au moins une paire de poutres de flexion reliées mécaniquement entre elles par au moins un élément de liaison, l'élément de flexion reliant mécaniquement la partie mobile et le support via la paire de poutres de flexion, l'une étant reliée mécaniquement directement au support et l'autre étant reliée mécaniquement directement à la partie mobile.

L'élément de liaison relie une première zone d'une des poutres de flexion à un première zone de l'autre poutre de flexion, et une deuxième zone de l'une des poutres de flexion est reliée à la masse et la deuxième zone de l'autre poutre de flexion est reliée au substrat. Les deux poutres sont parallèles entre elles et les deux poutres de flexion s'étendent dans le même sens de leur première zone vers leur deuxième zone.

Dans un mode avantageux, les premières zones des poutres sont situées d'un côté de l'axe de rotation et les deuxièmes zones des poutres sont situées de l'autre côté de l'axe de rotation.

L'une des poutres de flexion de la paire est reliée directement au support et l'autre poutre de flexion de la paire est reliée directement à la partie mobile et les deux poutres sont reliées directement entre elles au niveau d'une extrémité longitudinale. Sous l'effet d'une contrainte uniforme, les deux poutres vont s'allonger/se rétracter de la même manière. En les mettant en série, les deux allongements s'annulent. De même, en cas de contrainte non uniforme dans la direction hors plan, par exemple lorsque des contraintes sont induites dans la couche fine du substrat SOI indépendamment de l'épitaxie, les deux poutres vont aussi fléchir de la même manière. On annule là aussi l'effet de ces déformations en les mettant en série.

En d'autres termes, on réalise une structure comportant une articulation pivot comportant au moins un élément de flexion comprenant au moins une paire de poutres de flexion parallèles et reliées en série de sorte que le relâchement des contraintes n'entraîne le déplacement que des extrémités des poutres reliées entre elle, et non de l'extrémité de l'une des poutres reliée directement à la partie mobile. Les contraintes relâchées ne provoquent donc pas de déformation de la structure.

Dans un exemple particulièrement avantageux, le ou les éléments de flexion comporte(nt) plusieurs paires de poutres de flexion, les paires étant reliées mécaniquement entre elles, ce qui peut permettre de réaliser une articulation en rotation présentant une raideur proche de celle des articulations en rotation de l'état de la technique et sans perdre en maintien dans le plan.

Des caractéristiques préférentielles de l'invention sont divulguées dans les revendications dépendantes.

Dans un exemple de réalisation, les première et deuxième poutres sont reliées l'une à l'autre au niveau de leurs deux extrémités longitudinales, et la première poutre est destinée à être reliée directement au support au niveau d'une zone intermédiaire entre ses deux extrémités longitudinales et la deuxième poutre est destinée à être reliée directement à la partie mobile au niveau d'une zone intermédiaire entre ses deux extrémités longitudinales. Les zones intermédiaires sont avantageusement les milieux des première et deuxième poutres.

Dans un autre exemple de réalisation, la première poutre est destinée à être reliée par une de ses extrémités longitudinales au support et par une autre extrémité longitudinale à une extrémité longitudinale de la deuxième poutre, et la deuxième poutre est destinée à être reliée par l'autre de ses extrémités longitudinales à la partie mobile.

La charnière peut comporter au moins deux éléments de flexion. Dans un exemple avantageux, la charnière comporte un élément de liaison rigide entre au moins deux éléments de flexion s'étendant le long d'une direction parallèle à l'axe de rotation.

Les éléments de flexion peuvent être disposés de part et d'autre de la au moins une poutre de torsion.

Selon une caractéristique additionnelle, la charnière comporte deux éléments de torsion comportant chacun une poutre de torsion alignée avec l'axe de rotation. Par exemple, l'élément de torsion comporte une première poutre de torsion et une deuxième poutre de torsion, et ladite poutre de torsion forme la première poutre de torsion, les premières et deuxièmes poutres de torsion étant parallèles entre elles, et reliées entre elles par au moins une de leurs extrémités longitudinales, l'une des poutres de torsion étant reliée mécaniquement directement à la partie mobile et l'autre poutre de torsion étant reliée mécaniquement directement au support. La charnière peut comporter deux paires de poutres de torsion alignées l'une par rapport à l'autre le long de l'axe de rotation.

La charnière peut être réalisée à partir d'un empilement de couches et d'étapes de gravures, dans laquelle au moins les première et deuxième poutres de l'élément de flexion sont réalisées dans la même couche.

La présente invention a également pour objet une structure micromécanique et/nanomécanique comportant un support, une partie mobile dans la direction hors-plan et une charnière selon l'invention reliant la partie mobile au support.

La structure peut comporter des moyens de butée hors-plan pour la masse en éloignement et/ou en rapprochement du support.

La présente invention a également pour objet un système microélectromécanique comportant au moins une structure l'invention.

Le système peut comporter des moyens de mesure du déplacement de la partie mobile dans la direction hors-plan, comprenant au moins une jauge de contrainte.

### BRÈVE DESCRIPTION DES DESSINS

La présente invention sera mieux comprise sur la base de la description qui va suivre et des dessins en annexe sur lesquels:
La figure 1 est une vue de dessus d'une structure de l'état de la technique,
La figure 2 est une vue de dessus d'une structure selon un exemple de réalisation,
La figure 3 est une vue de dessus d'une structure selon un autre exemple de réalisation,
La figure 4 est une vue de dessus d'une structure selon un autre exemple de réalisation mettant en oeuvre un élément de liaison entre les éléments de flexion.
La figure 5A est une vue de dessus d'une structure selon un autre exemple de réalisation mettant en oeuvre des éléments de liaison entre les éléments de flexion.
La figure 5B est une vue de détail de la figure 5A.
La figure 6 est une vue de dessus d'une structure selon un autre exemple de réalisation.
La figure 7 est une vue de dessus d'une variante avantageuse S3' de la structure S3 de la figure 4.
La figure 8 est une vue de dessus d'une structure selon un autre exemple de réalisation.
La figure 9 est une vue de dessus d'une structure proche de celle de la figure 8 et mettant en oeuvre un élément de liaison entre les éléments de flexion.
La figure 10 est une vue de dessus d'une structure selon un autre exemple de réalisation mettant en oeuvre un seul élément de flexion.
La figure 11 est une vue de dessus d'une variante de la structure de la figure 3.
Les figures 12A, 12B et 12C sont des représentations schématiques d'une partie des étapes d'un exemple de procédé de réalisation d'une structure micromécanique et/ou nanomécanique.

### EXPOSÉ DÉTAILLÉ DE MODES DE RÉALISATION PARTICULIERS

La présente invention concerne les structures micromécaniques et/ou nanomécaniques, et plus particulièrement les structures MEMS et/ou NEMS appliquées par exemple à des accéléromètres, gyromètres, capteurs de gaz, des actionneurs...

Dans la présente demande on entend par « structure micromécanique », une structure micromécanique et/ou nanomécanique, une structure MEMS et/ou NEMS.

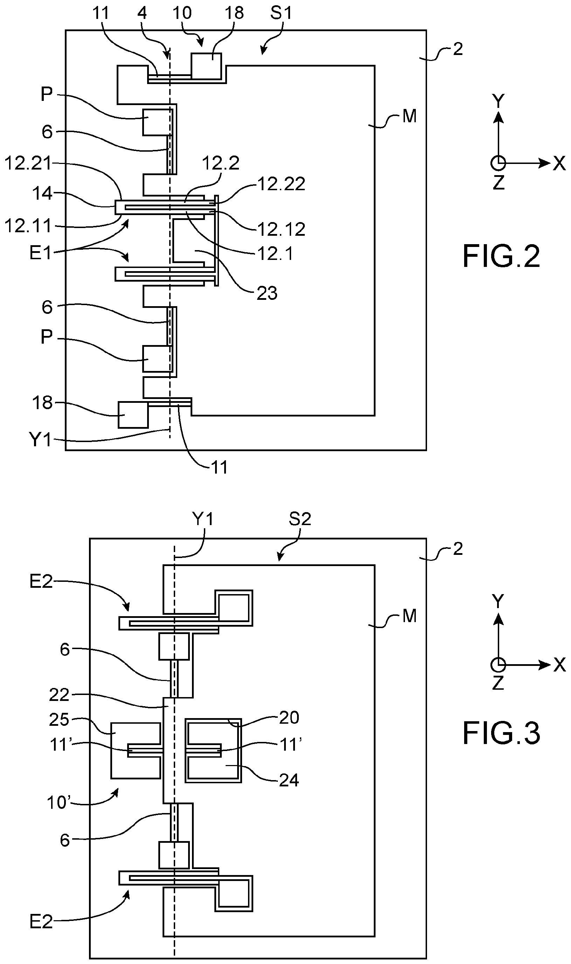

Sur la figure 2, on peut voir une représentation schématique d'un exemple d'une structure S1.

La structure S1 comporte une partie mobile M suspendue à un support 2 au moyen d'une charnière ou articulation pivot 4.

Par exemple, la partie mobile M peut être une masse inertielle dans le cas d'un accéléromètre, ou un micromiroir ou une plateforme orientable dans le cas d'un actionneur.

La partie mobile M s'étend dans le plan de la structure défini par les axes X et Y. Le plan de la structure est le plan moyen de la structure qui correspond au plan de la feuille dans la représentation de la figure 2.

La partie suspendue est destinée à se déplacer dans une direction hors-plan Z, orthogonale aux axes X et Y.

La charnière 4 a un axe Y1 parallèle à l'axe Y.

La charnière 4 est reliée à un bord de la partie suspendue M.

Dans l'exemple représenté, la charnière 4 comporte deux poutres 6 s'étendant le long de l'axe Y1 et destinées à être sollicitées en torsion lors du déplacement de la masse mobile dans la direction hors-plan. Chaque poutre de torsion 6 est reliée par une extrémité longitudinale à un plot d'ancrage P du support, et par une autre extrémité longitudinale à la partie mobile M.

La charnière comporte également deux éléments E1 s'étendant perpendiculairement à l'axe Y1 entre la partie mobile M et le support 2. Les éléments E1 sont destinés à être sollicités en flexion et seront désignés par la suite «éléments de flexion». Dans cet exemple, les éléments E1 sont disposés à l'intérieur de l'espace entre les deux poutres de torsion 6 dans la direction Y.

Dans cet exemple et de manière très avantageuse, la structure est symétrique par rapport à un axe X1, sauf les jauges de contrainte qui seront décrites ci-dessous, les éléments E1 sont alors disposés symétriquement par rapport à l'axe X1.

Les deux éléments E1 ont des structures similaires, un seul de ces éléments sera décrit en détail.

L'élément de flexion E1 comporte une paire de poutres de flexion reliées mécaniquement en série.

Dans cet exemple, chaque élément E1 comporte une paire de poutres de flexion 12.1, 12.2 reliées l'une à l'autre mécaniquement directement par une première extrémité longitudinale 12.11, 12.21 par une poutre transversale 14. Dans cet exemple, les extrémités 12.11 et 12.21 sont situées du même côté de l'axe de rotation Y1.

De manière avantageuse, l'axe de rotation Y1 passe par le milieu des poutres de flexion et par les poutres de torsion. Dans cette configuration, les poutres de flexion présentent leur raideur minimale.

La deuxième extrémité longitudinale 12.12 de la première poutre 12.1 est reliée directement à un plot d'ancrage 23 et la deuxième extrémité longitudinale 12.22 de la deuxième poutre 12.2 est reliée directement à la partie mobile M.

Les premières extrémités 12.11 et 12.21 des première et deuxième poutres sont libres de bouger ensemble, permettant aux poutres de se déformer ensemble sous l'effet de la libération des contraintes internes dans la direction X, sans que ces dernières n'appliquent d'effort sur la structure et la déforme. Puisque les poutres ont sensiblement les mêmes caractéristiques, i.e. sensiblement les mêmes dimensions aux marges dues au procédé de réalisation, et sont réalisées dans la ou les mêmes couches, les contraintes internes dans la direction X dans les deux poutres sont proches ou égales. Puisque les effets des contraintes internes sur les deux poutres sont sensiblement les mêmes, chaque poutre de flexion de chaque paire permet à l'autre poutre une libération de ses contraintes internes avec un effet réduit de l'élément de flexion sur la structure.

Dans l'exemple représenté les deux éléments E1 sont reliés au même plot d'ancrage, mais ceci n'est pas limitatif. Une structure avec un plot d'ancrage dédié à chaque poutre de flexion ne sort pas du cadre de la présente invention.

La structure S1 comporte également des moyens de mesure 10 du déplacement de la partie mobile. Dans cet exemple, ce sont des jauges de contrainte 11 suspendues entre la partie mobile et des plots d'ancrage 18 du support et sont disposées dans un plan distinct d'un plan parallèle au plan XY et contenant l'axe de rotation Y1.

Les jauges 11 sont disposées de sorte que, lorsqu'une jauge est sollicitée en traction, l'autre est sollicitée en torsion.

Cet exemple de réalisation présente l'avantage d'offrir une grande souplesse dans la direction hors-plan.

Sur la figure 3, on peut voir un autre exemple de réalisation d'une structure S2 proche de la structure S1, dans laquelle les poutres de torsion sont disposées entre les éléments E2 qui sont similaires aux éléments E1. Dans cet exemple les éléments E2 sont reliés à des plots d'ancrage distincts.

La structure S2 comporte également des moyens de mesure du déplacement 10' de la partie mobile comportant des jauges de contrainte, disposées au centre de la structure entre les deux poutres de torsion 6. Dans cet exemple et de manière avantageuse, les deux jauges 11' sont alignées l'une avec l'autre le long de l'axe X. La partie mobile comporte une fenêtre 20 dont un montant 22 s'étend le long de l'axe de rotation Y1. Une extrémité d'une jauge 11' est fixée à un bord du montant 22 de cette fenêtre 20, et l'autre extrémité de la jauge est fixée à un plot d'ancrage 24 disposé au droit de la fenêtre 20. L'autre jauge 11' est située à l'extérieur de la fenêtre 20, une extrémité étant fixée à l'autre bord dudit montant 22 et une extrémité étant fixée à un plot d'ancrage 25.

Les jauges 11' sont situées dans un plan différent du plan contenant l'axe de rotation Y1 de sorte à être sollicitées en traction ou en compression lorsque la partie mobile pivote autour de l'axe Y1.

L'alignement des jauges 11' a pour avantage de limiter l'effet des jauges sur la partie mobile. En effet dans cette disposition, les jauges opposent leurs contraintes internes, qui ne se libèrent pas. Au contraire dans la structure S1, les contraintes internes des jauges peuvent se libérer et provoquer une rotation de la partie mobile.

Dans cet exemple, les éléments de flexion E2 sont plus éloignés l'un de l'autre le long de l'axe de rotation que dans le cas de la structure S1, ce qui augmente la raideur vis-à-vis d'une rotation dans le plan.

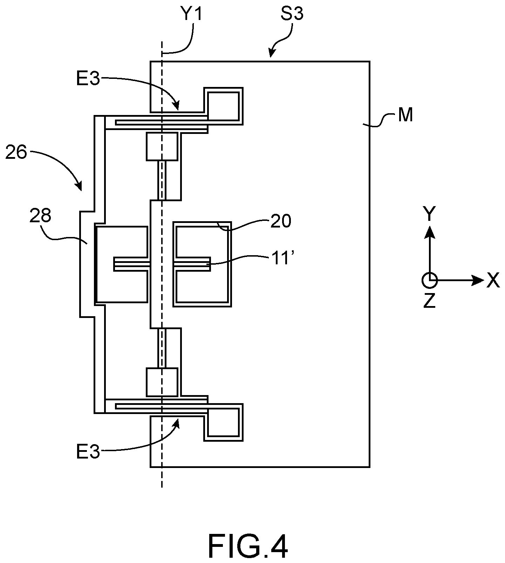

Sur la figure 4, on peut voir un autre exemple de réalisation d'une structure S3 particulièrement avantageux offrant une sensibilité aux déplacements dans la direction X réduite.

La structure S3 est similaire à la structure S2 et comporte en outre un moyen de liaison 26 reliant rigidement les deux éléments de flexion E3. Le moyen de liaison 26 comporte une poutre 28 rigide s'étendant sensiblement dans la direction Y. Dans cet exemple la poutre 28 a une forme de créneau qui tient compte du plot d'ancrage. En variante, la poutre 28 est droite.

Dans la présente demande, on entend par «poutre rigide », une poutre qui ne se déforme pas, ou de manière négligeable, sous les efforts subis dans l'utilisation normale de la structure. La poutre 28 relie les extrémités libres des poutres de flexion.

La poutre 28 a pour avantage de réduire les mouvements de la masse mobile dans le plan sans gêner la rotation de la masse mobile autour de l'axe Y1 en fonctionnement normal.

En effet, en mode de déformation normal, la poutre 28 n'a aucun effet sur le fonctionnement du dispositif car les extrémités libres des poutres se déplacent de la même manière, entraînant la poutre 28 avec elles sans effort supplémentaire.

Lorsqu'un effort dans le plan est appliqué à la partie mobile, en l'absence de la poutre 28, la partie mobile de la structure S3 est plus susceptible de se déplacer dans le plan qu'une partie mobile d'une structure avec des poutres de flexion plus larges telles que celle de la figure 1.

En effet le léger désalignement des deux poutres de flexion d'un ensemble E3 autorise un mode de déformation des deux poutres en flexion selon la direction Y qui génère une légère déformation résultante dans la direction X. Pour cela, l'extrémité libre des poutres de flexion dans le plan et se déplace en Y.

La poutre 28 lie les deux extrémités des deux ensembles E3, qui auraient tendance à se déplacer dans des mouvements incompatibles. Le mode de déformation dans le plan est alors interdit. La structure présente donc une rigidité en translation dans la direction X, équivalent à celle de la structure de l'état de la technique de la figure 1.

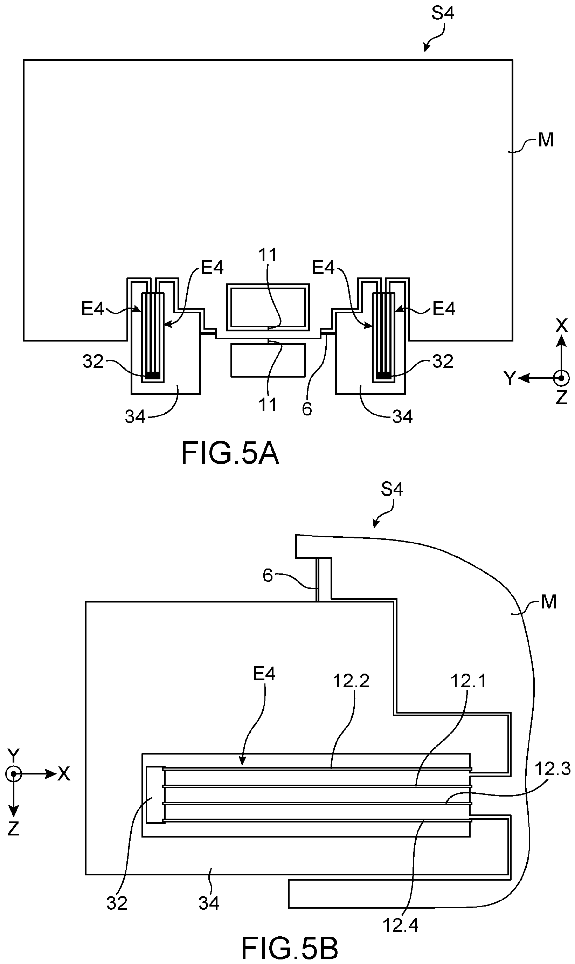

Sur les figures 5A et 5B, on peut voir un autre exemple de structure S4 mettant en oeuvre des moyens de liaison entre les éléments de flexion.

Dans cet exemple, la structure S4 comporte quatre éléments de flexion E4 i.e. quatre paires de poutres de flexion.

Les éléments de flexion E4 sont répartis deux par deux, symétriquement par rapport à un axe X1.

Les deux éléments de flexion E4 d'une paire comportent quatre poutres de flexion 12.1, 12.2, 12.3, 12.4 reliées entre elles au niveau de leur extrémité libre par un moyen de liaison 30 rigide. Dans cet exemple il s'agit d'une poutre rigide 32.

Dans cet exemple, deux poutres 12.1 et 12.3 sont reliées par une extrémité longitudinale à la partie mobile M, les deux poutres 12.2, 12.4 sont reliées par une extrémité longitudinale à un plot d'ancrage 34. Dans cet exemple, le plot d'ancrage 34 est commun aux deux poutres de flexion 12.2, 12.4 et à une poutre de torsion 6.

La poutre rigide 32 relie mécaniquement les extrémités libres des quatre poutres 12.1, 12.2, 12.3, 12.4.

La structure de l'autre paire d'éléments E4 est similaire à celle décrite ci-dessus.

Les poutres rigides 32 ont la même fonction que la poutre 28 de la structure S3. Elles limitent le déplacement dans le plan de la partie mobile. Les explications sur l'action de la poutre 28 s'appliquent aux poutres 32.

Les jauges 11 sont avantageusement alignées.

La structure S4 offre comme avantage d'offrir une structure relativement compacte par rapport à la structure S3.

La mise en oeuvre d'un lien rigide entre les éléments de flexion, comme c'est le cas dans les structures des figures 4, 5A et 5B, présente l'avantage de réduire la sensibilité selon la direction X, mais également d'augmenter la sensibilité dans la direction Z de déplacement. En effet, l'élément de liaison rigide entre les éléments de flexion interdit les modes de déformation dans la direction X autres que la compression qui s'appliquent aux jauges de contrainte.

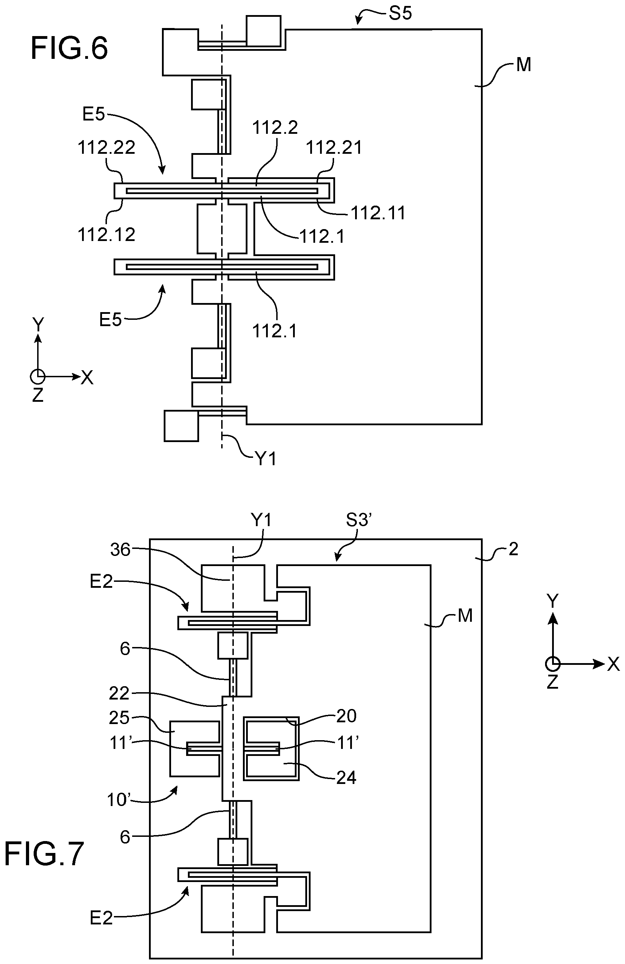

Sur la figure 6, on peut voir un autre exemple de réalisation d'une structure S5. Les éléments de flexion E5 comportent chacun une paire de poutres de flexion 112.1, 112.2 reliées entre elles mécaniquement par leurs extrémités libres. L'extrémité longitudinale 112.11 de la poutre 112.1 est reliée directement à l'extrémité longitudinale 112.21 de la poutre 112.2 et l'extrémité longitudinale 112.12 de la poutre 112.1 est reliée directement à l'extrémité longitudinale 112.22 de la poutre 112.2. L'élément de flexion E5 a alors sensiblement la forme d'un rectangle.

En outre, la poutre de flexion 112.2 est liée mécaniquement directement à la partie mobile M au niveau de son milieu, et la poutre 112.1 est liée mécaniquement au support au niveau de son milieu.

Dans l'exemple représenté les deux ensembles E5 sont reliés au même plot d'ancrage, mais ceci n'est pas limitatif.

Dans cet exemple, les contraintes internes aux poutres de flexion peuvent se libérer aux deux extrémités longitudinales de chaque poutre de flexion, sans s'appliquer entre le support et la partie mobile et provoquer leur déformation.

L'axe de rotation Y1 passe par les zones des poutres de flexion ancrées au support et à la partie mobile. Cette structure présente une raideur angulaire sensiblement plus élevée que celle de la structure S1, environ 4 fois plus élevée.

Cette structure présente l'avantage de permettre d'aligner les plots d'ancrage, l'attache de la masse et l'axe de rotation. Cette disposition alignée permet de réduire la sensibilité de la structure à une déformation du substrat, qui serait par exemple due à des dilatations différentes entre le substrat et un boîtier du dispositif comportant la structure.

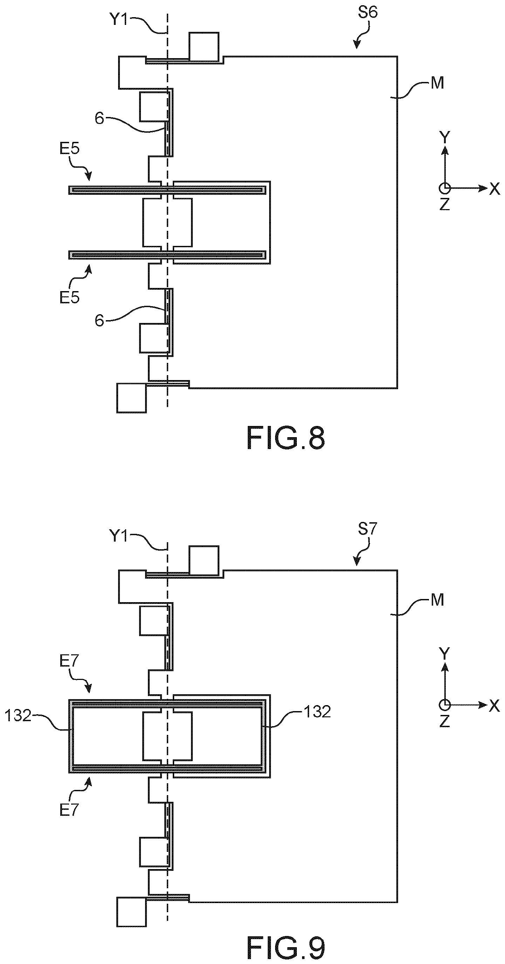

Dans cet exemple, la masse mobile est structurée de sorte à ménager un logement pour recevoir une partie de chaque élément de flexion. En variante, la structure S6 comporte un seul logement recevant les deux éléments de flexion comme cela est représenté sur la figure 8.

Sur la figure 7, on peut voir un exemple de structure S3' très avantageux qui reprend la structure S3 dans laquelle les plots d'ancrage 36 des éléments de flexion E3' sont disposés sur l'axe Y1. Cette structure présente une raideur angulaire faible, une sensibilité aux efforts dans le plan réduite et une sensibilité à la déformation du substrat réduite.

Sur la figure 9, on peut voir une structure S7 proche de la structure S6 comportant des moyens de liaison entre les éléments de flexion E7 et permettant d'augmenter le maintien dans la direction X. Dans l'exemple représenté, une poutre rigide 132 relie deux extrémités libres des ensembles E7 et une poutre rigide 132 relie les deux autres extrémités libres des ensembles E7.

En variante, une seule poutre rigide 132 est prévue entre deux extrémités libres de deux éléments. Cette variante présente une tenue réduite dans la direction X par rapport à la structure S7.

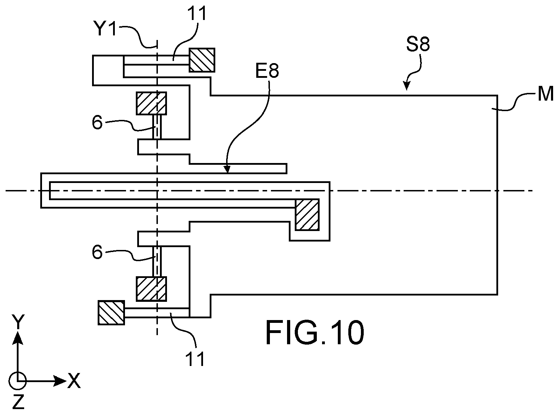

Sur la figure 10, on peut voir un autre exemple de structure S8 comportant un seul élément de flexion E8. De manière avantageuse, celui-ci est aligné avec un axe de symétrie assurant un équilibrage de la structure. Néanmoins une structure comportant un seul élément de flexion qui ne serait pas aligné avec un axe de symétrie de la structure ne sort pas du cadre de la présente invention.

La structure comporte également deux poutres de torsion 6 disposées de part et d'autre de l'élément de flexion E8 et des moyens de détection comprenant deux jauges de contrainte 11 disposées symétriquement de part et d'autre de l'élément de flexion E8. L'élément de flexion E8 est similaire à celui de la figure 2. En variante l'élément de flexion est similaire à l'élément de flexion E5 de la structure S5.

Une structure comportant un seul élément de flexion et une seule poutre de torsion ne sort pas du cadre de la présente invention.

Dans les exemples décrits, les moyens de détection comportent des jauges piézorésistifs. En variante les moyens de détection comportent des jauges piézoélectriques. En variante encore, les moyens de détection comportent une ou des poutres résonantes. Pour cela, une électrode est disposée de sorte à créer une force électrostatique sur la jauge afin de la mettre en résonance. La variation de la fréquence de résonance de la jauge due à la contrainte est mesurée au moyen d'un circuit spécifique qui peut être une boucle à verrouillage de phase.

Il sera compris que les agencements des éléments de flexion par rapport aux poutres de flexion et/ou par rapport aux moyens de détection peuvent varier.

Dans les exemples décrits et de manière avantageuse, l'axe de rotation Y1 passe par le milieu des poutres de flexion.

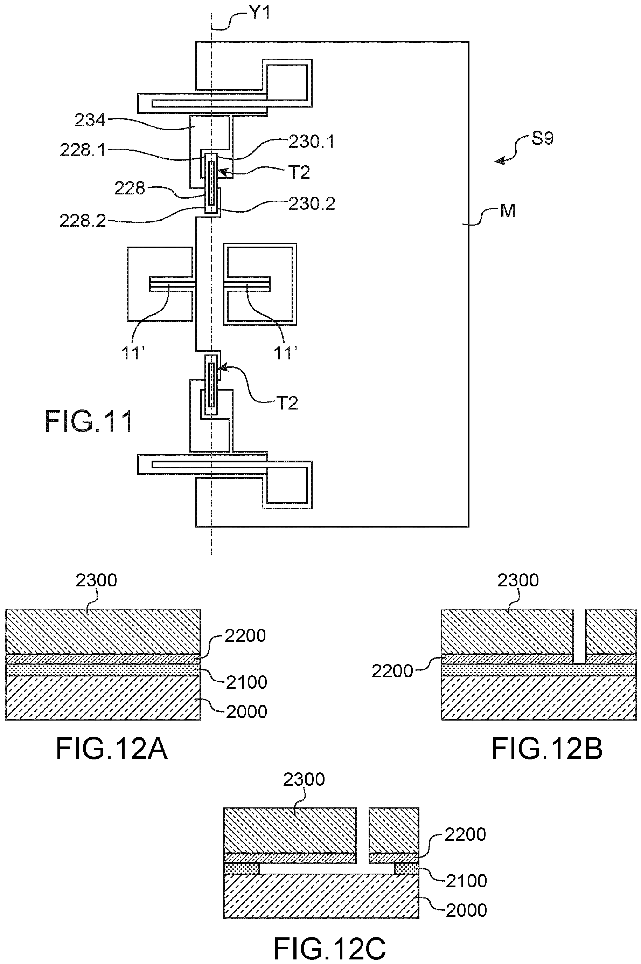

Sur la figure 11, on peut voir une structure S9 comportant des éléments de torsion selon une variante de réalisation.

Dans cette variante, les éléments de torsion T2 comportent au moins une paire de poutres de torsion reliées mécaniquement entre elles en série.

Les deux éléments de torsion ont des structures similaires, seul l'un des éléments de torsion T2 sera décrit en détail.

L'élément de torsion T2 comporte une paire de poutres de torsion 228, 230 disposées parallèlement l'une par rapport à l'autre et disposées symétriquement par rapport à l'axe de rotation Y1 de sorte que leurs actions combinées définissent effectivement l'axe de rotation Y1.

Les deux poutres de torsion sont reliées l'une à l'autre directement par leurs extrémités longitudinales 228.1, 230.1 et 228.2, 230.2 respectivement de sorte à former un rectangle. La liaison entre les extrémités longitudinales 228.1, 330.1 et la liaison entre les extrémités longitudinales 228.2, 230.2 sont rigides par rapport aux poutres 228, 230. Par ailleurs la poutre de flexion 228 est reliée directement au support via un plot d'ancrage 234, par exemple au niveau de son milieu, et la poutre de flexion 230 est reliée directement à la partie mobile, par exemple au niveau de son milieu.

Les extrémités 228.1, 230.1 et les extrémités 228.2, 330.2 des poutres 228, 230 sont libres de se déplacer, permettant aux contraintes internes aux poutres de torsion 228, 230 de se libérer. Les contraintes de poutres 228 et 230 étant très proches, leurs extrémités 228.1, 230.1 et 228.2, 230.2 vont se déplacer sensiblement identiquement et la liaison rigide entre elles n'entrave pas la libération des contraintes.

De préférence, les poutres de chaque paire de poutres d'un élément de flexion ont les mêmes dimensions.

Les différents éléments de flexion peuvent présenter des dimensions différentes les uns des autres.

En variante, les poutres de torsion 228 et 230 ne sont reliées que par l'une de leurs extrémités par exemple par les extrémités 228.2 et 230.2, et les extrémités 228.1 et 230.1 correspondent à la fixation au plot d'ancrage 234 et à la partie mobile respectivement.

Les structures S1 à S11 décrites ci-dessus comportent avantageusement au moins une butée inférieure et/ou au moins une butée supérieure pour limiter l'amplitude de déplacement hors-plan de la partie mobile et éviter un endommagement de la structure, par exemple lorsqu'un choc extérieur est appliqué à la structure. Les butées sont de type bien connu par l'homme du métier et ne seront pas décrites davantage.

Des butées pour limiter les mouvements dans le plan sont également envisageables.

Dans le cas où la structure est utilisée pour réaliser un actionneur, des moyens pour déplacer dans la direction hors-plan la partie mobile sont prévues, par exemple il s'agit de moyens électrostatiques.

En outre l'intégration des éléments de flexion, des poutres de torsion ou éléments de torsion dans la partie mobile peut être plus ou moins importante en fonction de l'espace disponible et/ou de la masse requise pour la partie mobile, ce qui permet d'offrir un grand nombre de configurations de structure pouvant s'adapter à de nombreuses applications.

La structure peut être réalisée par les techniques classiques de la microélectronique, sans ajouter d'étape complexe, par exemple le procédé de réalisation décrit dans le document EP2211185 peut être mis en oeuvre.

Un exemple de procédé de réalisation va être décrit ci-dessous.

Par exemple, à partir d'un substrat silicium sur isolant ou SOI (Silicon On Insulate), comportant une couche 2000 de silicium, une couche 2100 d'oxyde de silicium et une couche 2200 de silicium monocristallin, le procédé comporte :
- Une étape de formation d'une couche de silicium monocristallin 2300 par exemple par dépôt par épitaxie de silicium sur la couche 2200 (figure 12A).
- Une étape de structuration des couches 2200 et 2300 par photolithographie et gravure pour délimiter la partie mobile, la ou les jauges, et la charnière comportant la ou les poutres de torsion et le ou les éléments de flexion (figure 12B). Par exemple les jauges sont réalisées uniquement dans la couche 2200. Dans ce cas, on réalise préalablement à la formation de la couche 2300, la structuration de la couche 2200 pour former la ou les jauges, par exemple par gravure, et la protection de la ou des jauges par exemple par formation et structuration d'une couche d'oxyde. Les éléments de flexion sont réalisés dans la couche 2200 et une partie de la couche 2300 et les poutres de torsion sont réalisées dans la couche 2200 et dans toute l'épaisseur de la couche 2300.
- Une étape de libération de la partie mobile et de la charnière pargravure de la couche 2100 par exemple au moyen d'acide fluorhydrique (figure 12C).

Lors du dépôt de la couche 2300, des contraintes en compression peuvent être générées dans celle-ci, notamment en cas de dopage. L'implantation de dopant dans la couche 2200 peut aussi générer des contraintes dans cette couche inférieure

Lors de la libération de la partie mobile l'effet du relâchement des contraintes internes à la couche 2300 dans la direction X a un effet réduit sur la configuration de la structure.

Les charnières selon l'invention sont particulièrement adaptées à la réalisation de structures pour systèmes M&NEMS utilisés pour réaliser des capteurs ou des actionneurs.

## Revendications

1. Charnière pour structure micromécanique et/ou nanomécanique comportant un support (2), au moins une partie mobile (M) dans une direction hors-plan (Z) par rapport au support, ladite charnière étant destinée à suspendre la partie mobile au support permettant le déplacement hors-plan de la partie mobile (M), la charnière comportant au moins un élément de torsion comportant au moins une poutre (6) alignée avec l'axe de rotation (Y1) de la charnière et destinée à être déformée en torsion, ledit élément de torsion est reliée par une extrémité longitudinale à un plot d'ancrage du support, et par une autre extrémité longitudinale à la partie mobile (M), au moins un élément de flexion (E1, E6) destiné à être déformé en flexion, ledit élément de flexion (E1, E6) reliant mécaniquement la partie mobile (M) et le support (2) et comportant au moins une paire d'une première (12.1, 112.1) et d'une deuxième (12.2, 112.2) poutre parallèles entre elles et chaque poutre s'étendant dans un plan perpendiculairement à l'axe de rotation (Y1) de la charnière, la première poutre (12.1, 112.1) étant reliée directement au support (2) et la deuxième poutre (12.2, 112.2) étant reliée directement à la partie mobile (M), les première et deuxième poutres étant reliées l'une à l'autre par un premier élément de liaison au moins au niveau de l'une de leurs extrémités longitudinales, les première et deuxième poutres s'étendant dans le même sens à partir du premier élément de liaison, **caractérisée en ce que** les extrémités de la première poutre sont disposées de part et d'autre de l'axe de rotation (Y1) et les extrémités de la deuxième poutre étant disposées de part et d'autre de l'axe de rotation (Y1) et **en ce que** l'axe de rotation Y1 passe par le milieu des poutres de flexion.

2. Charnière selon la revendication 1, dans laquelle les première (112.1) et deuxième (112.2) poutres sont reliées l'une à l'autre au niveau de leurs deux extrémités longitudinales, et dans laquelle la première poutre (112.1) est destinée à être reliée directement au support (2) au niveau d'une zone intermédiaire entre ses deux extrémités longitudinales et la deuxième poutre (112.2) est destinée à être reliée directement à la partie mobile (M) au niveau d'une zone intermédiaire entre ses deux extrémités longitudinales.

3. Charnière selon la revendication 2, dans laquelle les zones intermédiaires sont les milieux des première et deuxième poutres.

4. Charnière selon la revendication 1, dans laquelle la première poutre (12.1) est destinée à être reliée par une de ses extrémités longitudinales au support (2) et par une autre extrémité longitudinale à une extrémité longitudinale de la deuxième poutre (12.2), et la deuxième poutre (12.2) est destinée à être reliée par l'autre de ses extrémités longitudinales à la partie mobile (M).

5. Charnière selon l'une des revendications 1 à 4, comportant au moins deux éléments de flexion (E1, E6).

6. Charnière selon la revendication précédente, comportant un élément de liaison rigide (26, 32) entre au moins deux éléments de flexion s'étendant le long d'une direction parallèle à l'axe de rotation (Y1).

7. Charnière selon la revendication 5 ou 6, dans laquelle les éléments de flexion sont disposés de part et d'autre de la au moins une poutre de torsion (6).

8. Charnière selon l'une des revendications 1 à 7, comportant deux éléments de torsion comportant chacun une poutre de torsion (6) alignée avec l'axe de rotation.

9. Structure selon l'une des revendications 1 à 8, dans laquelle l'élément de torsion (T2) comporte une première poutre de torsion (228) et une deuxième poutre de torsion (230), et ladite poutre de torsion forme la première poutre de torsion, les premières et deuxièmes poutres de torsion étant parallèles entre elles, et reliées entre elles par au moins une de leurs extrémités longitudinales, l'une des poutres de torsion étant reliée mécaniquement directement à la partie mobile et l'autre poutre de torsion étant reliée mécaniquement directement au support.

10. Charnière selon la revendication 9, comportant deux paires de poutres de torsion alignées l'une par rapport à l'autre le long de l'axe de rotation.

11. Charnière selon l'une des revendications 1 à 10, comprenant un empilement de couches en partie gravées, dans laquelle au moins les première et deuxième poutres de l'élément de flexion sont réalisées dans la même couche.

12. Structure micromécanique et/nanomécanique comportant un support, une partie mobile dans la direction hors-plan et une charnière selon l'une des revendications précédentes reliant la partie mobile au support.

13. Structure selon la revendication 12, comportant des moyens de butée hors-plan pour la masse en éloignement et/ou en rapprochement du support.

14. Système microélectromécanique comportant au moins une structure selon la revendication 12 ou 13.

15. Système microélectromécanique selon la revendication 14, comportant des moyens de mesure (10) du déplacement de la partie mobile dans la direction hors-plan, comprenant au moins une jauge de contrainte (11).

## Patentansprüche

1. Scharnier für eine mikromechanische und/oder nanomechanische Struktur, die einen Träger (2) und mindestens ein Teil (M) umfasst, das in Bezug auf den Träger in einer Richtung außerhalb der Ebene (Z) beweglich ist, wobei das Scharnier dazu bestimmt ist, das bewegliche Teil am Träger aufzuhängen und die Verschiebung des beweglichen Teils (M) außerhalb der Ebene zu ermöglichen, wobei das Scharnier mindestens ein Torsionselement, das mindestens einen Balken (6) umfasst, der mit der Drehachse (Y1) des Scharniers ausgerichtet und dazu bestimmt ist, durch Torsion verformt zu werden, wobei das Torsionselement durch ein Längsende mit einem Verankerungsstift des Trägers und durch ein anderes Längsende mit dem beweglichen Teil (M) verbunden ist, und mindestens ein Biegeelement (E1, E6) umfasst, das dazu bestimmt ist, durch Biegung verformt zu werden, wobei das Biegeelement (E1, E6) das bewegliche Teil (M) und den Träger (2) mechanisch verbindet und mindestens ein Paar aus einem ersten (12.1, 112.1) und einem zweiten (12.2, 112.2) Balken umfasst, die parallel zueinander sind, und sich jeder Balken in einer Ebene senkrecht zur Drehachse (Y1) des Scharniers erstreckt, wobei der erste Balken (12.1, 112.1) direkt mit dem Träger (2) verbunden ist und der zweite Balken (12.2, 112.2) direkt mit dem beweglichen Teil (M) verbunden ist, wobei der erste und der zweite Balken durch ein erstes Verbindungselement zumindest an einem ihrer Längsenden miteinander verbunden sind, wobei sich der erste und der zweite Balken von dem ersten Verbindungselement aus in die gleiche Richtung erstrecken, **dadurch gekennzeichnet, dass** die Enden des ersten Balkens auf beiden Seite der Drehachse (Y1) angeordnet sind und die Enden des zweiten Balkens auf beiden Seite der Drehachse (Y1) angeordnet sind und dass die Drehachse Y1 durch die Mitte der Biegebalken verläuft.

2. Scharnier nach Anspruch 1, wobei der erste (112.1) und der zweite (112.2) Balken an ihren beiden Längsenden miteinander verbunden sind, und wobei der erste Balken (112.1) dazu bestimmt ist, in einem Zwischenbereich zwischen ihren beiden Längsenden direkt mit dem Träger (2) verbunden zu werden, und der zweite Balken (112.2) dazu bestimmt ist, in einem Zwischenbereich zwischen ihren beiden Längsenden direkt mit dem beweglichen Teil (M) verbunden zu werden.

3. Scharnier nach Anspruch 2, wobei die Zwischenbereiche die Mitten des ersten und des zweiten Balkens sind.

4. Scharnier nach Anspruch 1, wobei der erste Balken (12.1) dazu bestimmt ist, mit einem seiner Längsenden mit dem Träger (2) und mit einem anderen Längsende mit einem Längsende des zweiten Balkens (12.2) verbunden zu werden, und der zweite Balken (12.2) dazu bestimmt ist, mit dem anderen seiner Längsenden mit dem beweglichen Teil (M) verbunden zu werden.

5. Scharnier nach einem der Ansprüche 1 bis 4, das mindestens zwei Biegeelemente (E1, E6) umfasst.

6. Scharnier nach dem vorhergehenden Anspruch, das ein starres Verbindungselement (26, 32) zwischen mindestens zwei Biegeelementen umfasst, das sich in einer Richtung parallel zur Drehachse (Y1) erstreckt.

7. Scharnier nach Anspruch 5 oder 6, wobei die Biegeelemente auf beiden Seiten des mindestens einen Torsionsbalkens (6) angeordnet sind.

8. Scharnier nach einem der Ansprüche 1 bis 7, das zwei Torsionselemente umfasst, die jeweils einen mit der Drehachse ausgerichteten Torsionsbalken (6) umfassen.

9. Struktur nach einem der Ansprüche 1 bis 8, wobei das Torsionselement (T2) einen ersten Torsionsbalken (228) und einen zweiten Torsionsbalken (230) umfasst, und der Torsionsbalken den ersten Torsionsbalken bildet, wobei der erste und der zweite Torsionsbalken parallel zueinander verlaufen und durch mindestens eines ihrer Längsenden miteinander verbunden sind, wobei einer der Torsionsbalken mechanisch direkt mit dem beweglichen Teil verbunden ist und der andere Torsionsbalken mechanisch direkt mit dem Träger verbunden ist.

10. Scharnier nach Anspruch 9, das zwei Paare von Torsionsbalken umfasst, die entlang der Drehachse zueinander ausgerichtet sind.

11. Scharnier nach einem der Ansprüche 1 bis 10, das einen Stapel von teilweise geätzten Schichten enthält, wobei mindestens der erste und der zweite Balken des Biegeelements in derselben Schicht ausgeführt sind.

12. Mikromechanische und/oder nanomechanische Struktur, die einen Träger, ein Teil, das in der Richtung außerhalb der Ebene beweglich ist, und ein Scharnier nach einem der vorhergehenden Ansprüche, das den beweglichen Teil mit dem Träger verbindet, umfasst.

13. Struktur nach Anspruch 12, das Anschlagmittel außerhalb der Ebene für die Masse, die sich vom Träger weg und/oder auf ihn zu bewegt.

14. Mikroelektromechanisches System, das mindestens eine Struktur nach Anspruch 12 oder 13 umfasst.

15. Mikroelektromechanisches System nach Anspruch 14, das Messmittel (10) für die Verschiebung des beweglichen Teils in der Richtung außerhalb der Ebene umfasst, die mindestens einen Dehnungsmessstreifen (11) umfasst.

## Claims

1. Hinge for a micromechanical and/or nanomechanical structure including a support (2), at least one movable part (M) in an out-of-plane direction (Z) with respect to the support, said hinge being intended to suspend the movable part from the support allowing for the out-of-plane displacement of the movable part (M), the hinge including at least one torsion element including at least one beam (6) aligned with the axis of rotation (Y1) of the hinge and intended to be deformed in torsion,
said torsion element being connected by one longitudinal end to an anchoring pad of the support, and by the other longitudinal end to the movable part (M),
at least one bending element (E1, E6) intended to be deformed in bending, said bending element (E1, E6) mechanically connecting the movable part (M) and the support (2) and including at least one pair of a first (12.1, 112.1) and of a second (12.2, 112.2) beam parallel with each other and each beam extending in a plane perpendicular to the axis of rotation (Y1) of the hinge, the first beam (12.1, 112.1) being directly connected to the support (2) and the second beam (12.2, 112.2) being directly connected to the movable part (M), the first and second beams being connected to one another by a first connecting element at least at one of the longitudinal ends thereof, the first and second beams extending in the same direction from the first connecting element, **characterized in that** the ends of the first beam are positioned on either side of the axis of rotation (Y1) and the ends of the second beam are positioned on either side of the axis of rotation (Y1), and **in that** the axis of rotation Y1 passes between the beams of flexion.

2. Hinge according to claim 1, wherein the first (112.1) and second (112.2) beams are connected to one another at the two longitudinal ends thereof, and wherein the first beam (112.1) is intended to be connected directly to the support (2) at an intermediate zone between the two longitudinal ends thereof and the second beam (112.2) is intended to be directly connected to the movable part (M) at an intermediate zone between the two longitudinal ends thereof.

3. Hinge according to claim 2, wherein the intermediate zones are the middles of the first and second beams.

4. Hinge according to claim 1, wherein the first beam (12.1) is intended to be connected by one of the longitudinal ends thereof to the support (2) and by another longitudinal end to a longitudinal end of the second beam (12.2), and the second beam (12.2) is intended to be connected by the other of the longitudinal ends thereof to the movable part (M).

5. Hinge according to one of claims 1 to 4, including at least two bending elements (E1, E6).

6. Hinge according to the preceding claim, including a rigid connecting element (26, 32) between at least two bending elements extending along a direction parallel to the axis of rotation (Y1).

7. Hinge according to claim 5 or 6, wherein the bending elements are disposed on either side of the at least one torsion beam (6).

8. Hinge according to one of claims 1 to 7, including two torsion elements each including a torsion beam (6) aligned with the axis of rotation.

9. Structure according to one of claims 1 to 8, wherein the torsion element (T2) including a first torsion beam (228) and a second torsion beam (230), and said torsion beam forms the first torsion beam, the first and second torsion beams being parallel to one another, and connected together by at least one of the longitudinal ends thereof, one of the torsion beams being mechanically connected directly to the movable part and the other torsion beam being mechanically connected directed to the support.

10. Hinge according to claim 9, including two pairs of torsion beams aligned relative to each other along the axis of rotation.

11. Hinge according to one of claims 1 to 10, made from a stack of layers and from etching steps, wherein at least the first and second beams of the bending element are made in the same layer.

12. Micromechanical and/or nanomechanical structure including a support, a movable part in the out-of-plane direction and a hinge according to one of the preceding claims connecting the movable part to the support.

13. Structure according to claim 12, including means of out-of-plane abutment for the mass moving away from and/or moving towards the support.

14. Microelectromechanical system including at least one structure according to claim 12 or 13.

15. Microelectromechanical system according to claim 14, including means for measuring (10) the displacement of the movable part in the out-of-plane direction, comprising at least one stress gauge (11).
